# FASCICULE DE BREVET EUROPEEN

(11) **EP 3 931 873 B1**
(45) Date de publication et mention de la délivrance du brevet: **18.01.2023**
(21) Numéro de dépôt: 20713708.4
(22) Date de dépôt: 21.02.2020
(51) Int. Cl.: H01L 27/146, H01L 27/30, H04N 5/363, H04N 9/04

(54) **CAPTEUR D'IMAGES COULEUR ET INFRAROUGE**
FARB- UND INFRAROTBILDSENSOR
COLOR AND INFRARED IMAGE SENSOR

(30) Priorité: 01.03.2019 FR 1902157
(43) Date de publication de la demande: 05.01.2022
(73) Titulaire: ISORG, 87068 Limoges Cedex 3 (FR)
(72) Inventeur: DUPOIRON, Camille, 38000 GRENOBLE (FR); BOUTHINON, Benjamin, 38000 GRENOBLE (FR)
(74) Mandataire: Cabinet Beaumont
(86) Numéro de dépôt international: PCT/FR2020/050337
(87) Numéro de publication internationale: WO 2020/178497

(56) Documents cités:
- WO-A1-2018/020977
- JP-A- 2017 208 496
- US-A1- 2018 301 509

## Description

### Domaine technique

La présente demande concerne un capteur d'images ou imageur électronique.

### Technique antérieure

Les capteurs d'images sont utilisés dans de nombreux domaines, en particulier dans les dispositifs électroniques grâce à leur miniaturisation. On retrouve des capteurs d'images que ce soit dans des applications d'interface homme-machine ou dans des applications de prise d'images.

Pour certaines applications, il est souhaitable de disposer d'un capteur d'images permettant de faire l'acquisition simultanée d'une image couleur et d'une image infrarouge. Un tel capteur d'images est appelé capteur d'images couleur et infrarouge dans la suite de la description. Un exemple d'application d'un capteur d'images couleur et infrarouge concerne l'acquisition d'une image infrarouge d'un objet sur lequel est projeté un motif infrarouge structuré. Des domaines d'utilisation de tels capteurs d'images sont notamment l'automobile, les drones, les téléphones intelligents, la robotique et les systèmes à réalité augmentée.

On appelle phase d'intégration d'un pixel la phase pendant laquelle le pixel collecte des charges sous l'action d'un rayonnement incident. La phase d'intégration est généralement suivie d'une phase de lecture pendant laquelle une mesure de la quantité de charges collectées par le pixel est réalisée.

Plusieurs contraintes sont à prendre en compte pour la conception d'un capteur d'images couleur et infrarouge. Premièrement, la résolution des images couleur acquises ne doit pas être inférieure à celle obtenue avec un capteur d'images couleur classique.

Deuxièmement, pour certaines applications, il peut être souhaitable que le capteur d'images soit du type à obturateur global, également appelé Global Shutter, c'est-à-dire mettant en oeuvre un procédé d'acquisition d'images dans lequel les débuts et fins des phases d'intégration des pixels sont simultanés. Ceci peut être le cas notamment pour l'acquisition d'une image infrarouge d'un objet sur lequel est projeté un motif infrarouge structuré.

Troisièmement, il est souhaitable que la taille des pixels du capteur d'images soit la plus petite possible. Quatrièmement, il est souhaitable que le facteur de remplissage de chaque pixel, qui correspond au rapport entre la surface, en vue de dessus, de la zone du pixel participant de façon active à la captation du rayonnement incident et la surface totale, en vue de dessus, du pixel, soit le plus grand possible.

Il peut être difficile de concevoir un capteur d'images couleur et infrarouge qui satisfasse à l'ensemble des contraintes décrites précédemment. JP 2017 208496 A décrit un capteur d'images couleur et infrarouge selon l'art antérieur.

### Résumé de l'invention

Un mode de réalisation pallie tout ou partie des inconvénients des capteurs d'images couleur et infrarouge décrits précédemment.

Selon un mode de réalisation, la résolution des images couleur acquises par le capteur d'images couleur et infrarouge est supérieure à 2560 ppi, de préférence supérieure à 8530 ppi.

Selon un mode de réalisation, le procédé d'acquisition d'une image infrarouge est du type Global Shutter.

Selon un mode de réalisation, la taille des pixels du capteur d'images couleur et infrarouge est inférieure à 10 µm, de préférence inférieure à 3 µm.

Selon un mode de réalisation, le facteur de remplissage de chaque pixel du capteur d'images couleur et infrarouge est supérieur à 50 %, de préférence supérieur à 80 %.

L'invention revendiquée, prévoit un capteur d'images couleur et infrarouge comprenant un substrat en silicium, des transistors MOS formés dans le substrat et sur le substrat, des premières photodiodes formées au moins en partie dans le substrat, une couche photosensible recouvrant le substrat et des filtres de couleur, la couche photosensible étant interposée entre le substrat et les filtres de couleur. Le capteur d'images comprend en outre des premières et deuxièmes électrodes de part et d'autre de la couche photosensible et délimitant des deuxièmes photodiodes dans la couche photosensible, les premières photodiodes étant configurées pour absorber les ondes électromagnétiques du spectre visible et d'une première partie du spectre infrarouge et la couche photosensible étant configurée pour absorber les ondes électromagnétiques du spectre visible et pour laisser passer les ondes électromagnétiques de ladite première partie du spectre infrarouge.

Selon un mode de réalisation, le capteur d'images comprend en outre un filtre infrarouge, les filtres de couleur étant interposés entre la couche photosensible et le filtre infrarouge, le filtre infrarouge étant configuré pour laisser passer les ondes électromagnétiques du spectre visible, pour laisser passer les ondes électromagnétiques de ladite première partie du spectre infrarouge et pour bloquer les ondes électromagnétiques d'au moins une deuxième partie du spectre infrarouge entre le spectre visible et la première partie du spectre infrarouge.

Selon un mode de réalisation, le capteur d'images comprend en outre une matrice de lentilles interposée entre la couche photosensible et le filtre infrarouge.

Selon l'invention revendiquée, le capteur d'images comprend en outre, pour chaque pixel de l'image couleur à acquérir, au moins des premier, deuxième et troisième sous-pixels comprenant chacun l'une des deuxièmes photodiodes, l'une des premières photodiodes, et l'un des filtres de couleur, les filtres de couleur des premier, deuxième et troisième sous-pixels laissant passer les ondes électromagnétiques dans des plages de fréquences différentes du spectre visible.

Selon un mode de réalisation, pour chaque pixel de l'image couleur à acquérir, la deuxième électrode est commune aux premier, deuxième et troisième sous-pixels.

Selon l'invention revendiquée, le capteur d'images comprend en outre, pour chaque pixel de l'image couleur à acquérir, au moins un quatrième sous-pixel comprenant l'une des deuxièmes photodiodes et l'un des filtres de couleur, le filtre de couleur du quatrième sous-pixel étant configuré pour bloquer les ondes électromagnétiques du spectre visible et pour laisser passer les ondes électromagnétiques dans une troisième partie du spectre infrarouge entre le spectre visible et la première partie du spectre infrarouge, la couche photosensible étant configurée pour absorber les ondes électromagnétiques dans ladite troisième partie du spectre infrarouge.

Selon un mode de réalisation, le capteur d'images comprend en outre, pour chaque premier, deuxième et troisième sous-pixel, un circuit de lecture relié à la deuxième photodiode et à la première photodiode.

Selon un mode de réalisation, le circuit de lecture est configuré pour transférer des premières charges électriques générées dans la première photodiode vers une première piste conductrice électriquement et configuré pour transférer des deuxièmes charges générées dans la deuxième photodiode vers la première piste conductrice électriquement ou une deuxième piste conductrice électriquement.

Selon un mode de réalisation, les premières photodiodes sont agencées en rangées et en colonnes et les circuits de lecture sont configurés pour commander la génération des premières charges pendant des premiers intervalles de temps simultanés pour toutes les premières photodiodes du capteur d'images.

Selon un mode de réalisation, les deuxièmes photodiodes sont agencées en rangées et en colonnes et les circuits de lecture sont configurés pour commander la génération des deuxièmes charges pendant des deuxièmes intervalles de temps simultanés pour toutes les deuxièmes photodiodes du capteur d'images ou décalés dans le temps d'une rangée de deuxièmes photodiodes à l'autre.

Selon un mode de réalisation, les circuits de lecture sont configurés pour commander une première phase d'intégration pour les premières photodiodes ayant une première durée et pour commander une deuxième phase d'intégration pour les deuxièmes photodiodes ayant une deuxième durée différente de la première durée.

Selon un mode de réalisation, chaque circuit de lecture comprend au moins un premier transistor MOS monté en suiveur, la deuxième photodiode ayant une première électrode reliée directement à la grille du premier transistor MOS et la deuxième photodiode ayant une deuxième électrode reliée à la grille du premier transistor MOS, ou à la grille d'un deuxième transistor MOS monté en suiveur, par l'intermédiaire d'un troisième transistor MOS.

Selon un mode de réalisation, la couche photosensible est en matériaux organiques et/ou contient des boîtes quantiques.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective éclatée, partielle et schématique, d'un mode de réalisation d'un capteur d'images couleur et infrarouge ;
la figure 2 est une vue en coupe, partielle et schématique, du capteur d'images de la figure 1 illustrant un mode de réalisation des électrodes du capteur d'images ;
la figure 3 est une vue en coupe, partielle et schématique, du capteur d'images de la figure 1 illustrant un autre mode de réalisation des électrodes ;
la figure 4 est un schéma électrique d'un mode de réalisation d'un circuit de lecture d'un sous-pixel du capteur d'images de la figure 1 ;
la figure 5 est un schéma électrique d'un autre mode de réalisation du circuit de lecture ;
la figure 6 est un schéma électrique d'un autre mode de réalisation du circuit de lecture ;
la figure 7 est un schéma électrique d'un autre mode de réalisation du circuit de lecture ;
la figure 8 est un schéma électrique d'un autre mode de réalisation du circuit de lecture ;
la figure 9 est un schéma électrique d'un autre mode de réalisation du circuit de lecture ;
la figure 10 est un chronogramme de signaux d'un mode de réalisation d'un procédé de fonctionnement du capteur d'images ayant le circuit de lecture de la figure 4 ;
la figure 11 est un chronogramme de signaux d'un autre mode de réalisation d'un procédé de fonctionnement du capteur d'images ayant le circuit de lecture de la figure 4 ;
la figure 12 est un chronogramme de signaux d'un mode de réalisation d'un procédé de fonctionnement du capteur d'images ayant le circuit de lecture de la figure 9 ; et
la figure 13 est un chronogramme de signaux d'un mode de réalisation d'un procédé de fonctionnement du capteur d'images ayant le circuit de lecture de la figure 9.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les éléments utiles à la compréhension des modes de réalisation décrits ont été représentés et sont détaillés. En particulier, l'utilisation faite des capteurs d'images décrits ci-après n'a pas été détaillée.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un capteur d'images dans une position normale d'utilisation. Sauf précision contraire, les expressions "environ", "approximativement", "sensiblement", et "de l'ordre de" signifient à 10 % près, de préférence à 5 % près.

Sauf précision contraire, lorsque l'on fait référence à deux éléments connectés entre eux, cela signifie directement connectés sans élément intermédiaire autre que des conducteurs, et lorsque l'on fait référence à deux éléments reliés ou couplés entre eux, cela signifie que ces deux éléments peuvent être directement reliés (connectés) ou reliés par l'intermédiaire d'un ou plusieurs autres éléments. De plus, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas. En outre, on considère ici que les termes "isolant" et "conducteur" signifient respectivement "isolant électriquement" et "conducteur électriquement".

La transmittance d'une couche correspond au rapport entre l'intensité du rayonnement sortant de la couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %. Dans la suite de la description, l'indice de réfraction d'un matériau correspond à l'indice de réfraction du matériau pour la plage de longueurs d'onde du rayonnement capté par le capteur d'images. Sauf indication contraire, l'indice de réfraction est considéré sensiblement constant sur la plage de longueurs d'onde du rayonnement utile, par exemple égal à la moyenne de l'indice de réfraction sur la plage de longueurs d'onde du rayonnement capté par le capteur d'images.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,4 µm.

Un pixel d'une image correspond à l'élément unitaire de l'image captée par un capteur d'images. Lorsque le dispositif optoélectronique est un capteur d'images couleur, il comprend en général pour chaque pixel de l'image couleur à acquérir au moins trois composants qui font l'acquisition chacun d'un rayonnement lumineux sensiblement dans une seule couleur, c'est-à-dire dans une plage de longueurs d'onde inférieure à 100 nm (par exemple, le rouge, le vert et le bleu). Chaque composant peut comprendre au moins un photodétecteur.

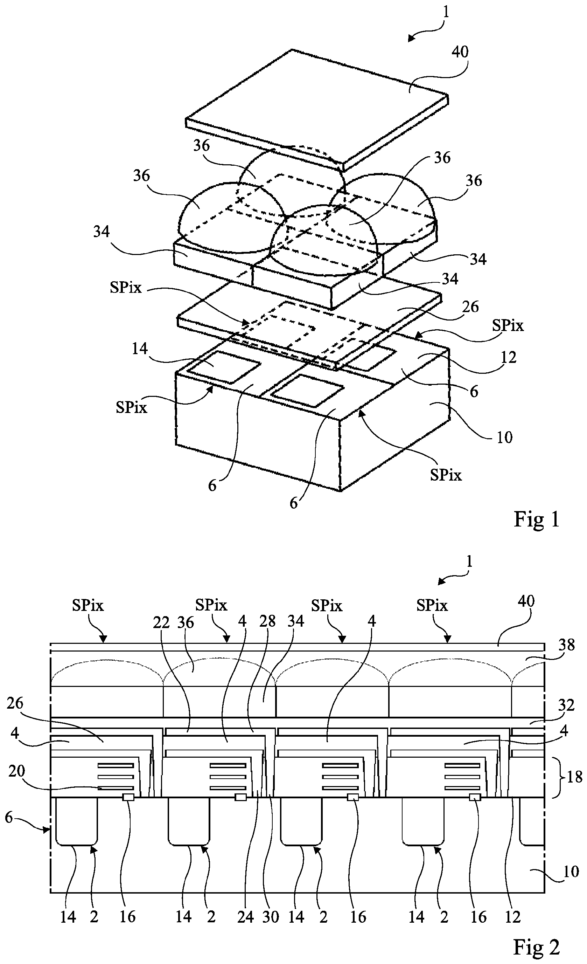

La figure 1 est une vue éclatée en perspective, partielle et schématique, et la figure 2 est une vue en coupe, partielle et schématique, d'un mode de réalisation d'un capteur d'images couleur et infrarouge 1. Le capteur d'images 1 comprend une matrice de premiers capteurs de photons 2, également appelés photodétecteurs, adaptés à capter une image infrarouge, et une matrice de deuxièmes photodétecteurs 4, adaptés à capter une image couleur. Les matrices de photodétecteurs 2 et 4 sont associées à une matrice de circuits de lecture 6 réalisant la mesure des signaux captés par les photodétecteurs 2 et 4. Par circuit de lecture, on entend un ensemble de transistors de lecture, d'adressage et de commande du pixel ou sous-pixel défini par les photodétecteurs 2 et 4 correspondants.

Dans le capteur d'images 1, la matrice de photodétecteurs couleur 4 recouvre la matrice de photodétecteurs infrarouges 2. Pour chaque pixel de l'image couleur à acquérir, on appelle sous-pixel SPix du capteur d'images 1 la partie du capteur d'images 1 comprenant le photodétecteur 4 permettant l'acquisition du rayonnement lumineux dans une partie restreinte du rayonnement visible de l'image à acquérir.

On a représenté sur les figures 1 et 2 quatre sous-pixels SPix. A des fins de clarté, seuls certains éléments du capteur d'images 1 présents en figure 2 sont représentés en figure 1. Le capteur d'images 1 comprend de bas en haut en figure 2 :
un substrat 10 semiconducteur comprenant une face supérieure 12, de préférence plane ;
pour chaque sous-pixel SPix, au moins une région semiconductrice dopée 14 formée dans le substrat 12 et faisant partie de la photodiode infrarouge 2 ;
des composants électroniques 16 des circuits de lecture 6 situés dans le substrat 10 et/ou sur la face 12, un seul composant 16 étant représenté par sous-pixel SPix en figure 2 ;
un empilement 18 de couches isolantes recouvrant la face 12, des pistes conductrices 20 étant situées sur l'empilement 18 et entre les couches isolantes de l'empilement 18 ;
pour chaque sous-pixel SPix, une électrode 22 reposant sur l'empilement 18 et reliée au substrat 10, à l'un des composants 16 ou à l'une des pistes conductrices 20 par un via conducteur 24 ;
une couche active 26 recouvrant toutes les électrodes 22 et recouvrant l'empilement 18 entre les électrodes 22 ;
pour chaque sous-pixel SPix, une électrode 28 reposant sur la couche active 26 et reliée au substrat 10, à l'un des composants 16 ou à l'une des pistes conductrices 20 par un via conducteur 30 ;
une couche isolante 32 recouvrant toutes les électrodes 28 et recouvrant la couche active 26 entre les électrodes 28 ;
pour chaque sous-pixel SPix, un filtre de couleur 34 recouvrant la couche isolante 32 ;
pour chaque sous-pixel SPix, une microlentille 36 recouvrant le filtre de couleur 34 ;
une couche isolante 38 recouvrant les microlentilles 36 ; et un filtre 40 recouvrant la couche isolante 36.

Les sous-pixels SPix peuvent être répartis en rangées et en colonnes. Dans le présent mode de réalisation, chaque sous-pixel SPix a, dans une direction perpendiculaire à la face 12, une base carrée ou rectangulaire de côté variant de 0,1 µm à 100 µm, par exemple égal à environ 3 µm. Toutefois, chaque sous-pixel SPix peut avoir une base de forme différente, par exemple hexagonale.

Dans le présent mode de réalisation, la couche active 26 est commune à l'ensemble des sous-pixels SPix du capteur d'images 1. La zone active de chaque photodétecteur couleur 4 correspond à la zone dans laquelle la majorité du rayonnement incident est absorbée et convertie en signal électrique par le photodétecteur couleur 4 et correspond sensiblement à la partie de la couche active 26 située entre l'électrode inférieure 22 et l'électrode supérieure 28.

Selon un mode de réalisation, chaque photodétecteur infrarouge 2 est adapté à capter un rayonnement électromagnétique dans une plage de longueurs d'onde comprises entre 400 nm et 1100 nm. Selon un mode de réalisation, la couche active 26 est adaptée à capter un rayonnement électromagnétique dans une plage de longueurs d'onde comprises entre 400 nm et 700 nm, c'est-à-dire à absorber seulement la lumière visible. Selon un autre mode de réalisation, la couche active 26 est adaptée à capter un rayonnement électromagnétique dans une plage de longueurs d'onde comprises entre 400 nm et 920 nm, c'est-à-dire la lumière visible et une partie du proche infrarouge. Les photodétecteurs peuvent être réalisés en matériaux organiques. Les photodétecteurs peuvent correspondre à des photodiodes organiques (OPD, de l'anglais Organic Photodiode) ou à des photorésistances organiques. Dans la suite de la description, on considère que les photodétecteurs correspondent à des photodiodes.

Le filtre 40 est adapté à laisser passer la lumière visible, à laisser passer la partie du rayonnement infrarouge sur la plage de longueurs d'onde infrarouges d'intérêt pour l'acquisition de l'image infrarouge et à bloquer le reste du reste du rayonnement incident et notamment le reste du rayonnement infrarouge en dehors de la plage de longueurs d'onde infrarouges d'intérêt. Selon un mode de réalisation, la plage de longueurs d'onde infrarouges d'intérêt peut correspondre à une plage de 50 nm centrée sur la longueur d'onde attendue du rayonnement infrarouge, par exemple centrée sur la longueur d'onde de 940 nm ou centrée sur la longueur d'onde de 850 nm. Le filtre 40 peut être un filtre interférentiel et/ou comprendre des couches absorbantes et/ou réfléchissantes.

Les filtres de couleur 34 peuvent correspondre à des blocs de résine colorée. Chaque filtre de couleur 34 est adapté à laisser passer le rayonnement infrarouge, par exemple à une longueur d'onde entre 700 nm et 1 mm, et, pour au moins certains des filtres de couleur, à laisser passer une plage de longueurs d'onde de la lumière visible. Pour chaque pixel de l'image couleur à acquérir, le capteur d'images peut comprendre un sous-pixel SPix dont le filtre de couleur 34 est adapté à ne laisser passer que la lumière bleue, par exemple dans la plage de longueurs d'onde de 430 nm à 490 nm, un sous-pixel SPix dont le filtre de couleur 34 est adapté à ne laisser passer que la lumière verte, par exemple dans la plage de longueurs d'onde de 510 nm à 570 nm et un sous-pixel SPix dont le filtre de couleur 34 est adapté à ne laisser passer que la lumière rouge, par exemple dans la plage de longueurs d'onde de 600 nm à 720 nm.

Selon un mode de réalisation, la couche active 26 est adaptée à capter un rayonnement électromagnétique dans une plage de longueurs d'onde comprises entre 400 nm et 700 nm, c'est-à-dire à absorber seulement la lumière visible. Les filtres de couleur 34 peuvent alors être répartis selon une matrice de Bayer. De ce fait, pour chaque sous-pixel SPix, le photodétecteur couleur 4 du sous-pixel ne capte que la partie de la lumière visible ayant traversé le filtre de couleur 34 du sous-pixel.

Selon un autre mode de réalisation, la couche active 26 est adaptée à capter un rayonnement électromagnétique dans une plage de longueurs d'onde comprises entre 400 nm et 920 nm, c'est-à-dire la lumière visible et une partie du proche infrarouge. Dans ce cas, l'un des filtres de couleur 34 est adapté à laisser passer seulement le rayonnement infrarouge et à bloquer la lumière visible. L'une des photodiodes couleur 4 joue alors le rôle de photodiode pour le proche infrarouge. Ceci peut être avantageux pour l'acquisition d'images couleur, notamment en cas de faible luminosité. Le rayonnement infrarouge capté par les photodiodes infrarouges 2 correspond à une plage de longueurs d'onde différente du rayonnement infrarouge capté par la photodiode couleur 4 jouant le rôle de photodiode pour le proche infrarouge.

Selon un mode de réalisation, le substrat 10 semiconducteur est en silicium, de préférence en silicium monocristallin. Le substrat peut être du type silicium sur isolant ou SOI (sigle anglais pour Silicon On Insulator) comprenant un empilement d'une couche de silicium sur une couche isolante. Selon un mode de réalisation, les composants électroniques 16 comprennent des transistors, notamment des transistors à effet de champ à grille métal-oxyde, également appelés transistors MOS. Les photodiodes infrarouges 2 sont des photodiodes inorganiques, de préférence en silicium. Chaque photodiode infrarouge 2 comprend au moins la région de silicium dopée 14 qui s'étend dans le substrat 10 depuis la face 12. Selon un mode de réalisation, le substrat 10 est non dopé ou faiblement dopé d'un premier type de conductivité, par exemple de type P et chaque région 14 est une région dopée, du type de conductivité opposé au substrat 10, par exemple de type N. La profondeur de chaque région 14, mesurée depuis la face 12, peut être comprise entre 1 µm et 12 µm. La photodiode infrarouge 2 peut correspondre à une photodiode pincée. Des exemples de photodiodes pincées sont décrits notamment dans le brevet US 6 677 656. Il s'agit par exemple de photodiodes séparées par des tranchées d'isolation profondes pour faciliter la collecte des charges générées en profondeur dues au rayonnement dans le proche infrarouge.

Les pistes conductrices 20 et les vias conducteurs 24, 30 peuvent être en un matériau métallique, par exemple l'argent (Ag), l'aluminium (Al), l'or (Au), le cuivre (Cu), le nickel (Ni), le titane (Ti) et le chrome (Cr). Les pistes conductrices 20 et les vias conducteurs 24, 30 peuvent avoir une structure monocouche ou multicouche. Chaque couche isolante de l'empilement 18 peut être en un matériau inorganique, par exemple en oxyde de silicium (SiO₂) ou un nitrure de silicium (SiN).

Chaque électrode 22, 28 est au moins partiellement transparente au rayonnement lumineux qu'elle reçoit. Chaque électrode 22, 28 peut être en un matériau conducteur et transparent, par exemple en oxyde conducteur et transparent ou TCO (acronyme anglais pour Transparent Conductive Oxide), en nanotubes de carbone, en graphène, en un polymère conducteur, en un métal, ou en un mélange ou un alliage d'au moins deux de ces composés. Chaque électrode 22, 28 peut avoir une structure monocouche ou multicouche.

Des exemples de TCO adaptés à la réalisation de chaque électrode 22, 28 sont l'oxyde d'indium-étain (ITO, de l'anglais Indium Tin Oxide), l'oxyde d'aluminium-zinc (AZO, de l'anglais Aluminium Zinc Oxide) l'oxyde de gallium-zinc (GZO, de l'anglais Gallium Zinc Oxide), le nitrure de titane (TiN), l'oxyde de molybdène (MoO₃) et l'oxyde de tungstène (WO₃). Un exemple de polymère conducteur adapté à la réalisation de chaque électrode 22, 28 est le polymère connu sous la dénomination PEDOT:PSS, qui est un mélange de poly(3,4)-éthylènedioxythiophène et de polystyrène sulfonate de sodium et la polyaniline, également appelé PAni. Des exemples de métaux adaptés à la réalisation de chaque électrode 22, 28 sont l'argent, l'aluminium, l'or, le cuivre, le nickel, le titane et le chrome. Un exemple de structure multicouche adaptée à la réalisation de chaque électrode 22, 28 est une structure multicouche d'AZO et d'argent de type AZO/Ag/AZO.

L'épaisseur de chaque électrode 22, 28 peut être comprise entre 10 nm et 5 µm, par exemple de l'ordre de 30 nm. Dans le cas où l'électrode 22, 28 est métallique, l'épaisseur de l'électrode 22, 28 est inférieure ou égale à 20 nm, de préférence inférieure ou égale à 10 nm.

Chaque couche isolante 32, 38 peut être réalisée en polymère fluoré, notamment le polymère fluoré commercialisé sous l'appellation Cytop par la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en poly(téréphtalate d'éthylène) (PET, sigle anglais polyethylene terephthalate), en poly(naphtalate d'éthylène) (PEN, sigle anglais pour polyethylene naphthalate), en polymères d'oléfine cyclique (COP, sigle anglais pour Cyclo Olefin Polymer), en polydiméthylsiloxane (PDMS), en une résine de photolithographie, en résine époxy, en résine acrylate ou en un mélange d'au moins deux de ces composés. A titre de variante, chaque couche isolante 32, 38 peut être réalisée en un diélectrique inorganique, notamment en nitrure de silicium, en oxyde de silicium ou en oxyde d'aluminium (Al₂O₃). L'oxyde d'aluminium peut être déposé par dépôt de couches minces atomiques (ALD, sigle anglais pour Atomic Layer Deposition). L'épaisseur maximale de chaque couche isolante 32, 38 peut être comprise entre 50 nm et 2 µm, par exemple de l'ordre de 100 nm.

La couche active 26 peut comprendre des petites molécules, des oligomères ou des polymères. Il peut s'agir de matériaux organiques ou inorganiques, notamment des boîtes quantiques. La couche active 26 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la couche active 26 peut être comprise entre 50 nm et 2 µm, par exemple de l'ordre de 200 nm.

Des exemples de polymères semiconducteurs de type P adaptés à la réalisation de la couche active 26 sont le poly(3-hexylthiophène) (P3HT), le poly[N-9'-heptadécanyl-2,7-carbazole-alt-5,5-(4,7-di-2-thiényl-2',1',3'-benzothiadiazole)] (PCDTBT), le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C), le poly[2-méthoxy-5-(2-éthyl-hexyloxy)-1,4-phénylène-vinylène] (MEH-PPV) ou le poly[2,6-(4,4-bis-(2-éthylhexyl)-4H-cyclopenta [2,1-*b*;3,4-*b*']dithiophène)-*alt-*4,7(2,1,3-benzothiadiazole)] (PCPDTBT).

Des exemples de matériaux semiconducteurs de type N adaptés à la réalisation de la couche active 26 sont les fullerènes, notamment le C60, le [6,6]-phényl-C₆₁-butanoate de méthyle ([60]PCBM), le [6,6]-phényl-C₇₁-butanoate de méthyle ([70]PCBM), le pérylène diimide, l'oxyde de zinc (ZnO) ou des nanocristaux permettant la formation de boîtes quantiques (en anglais quantum dots).

La couche active 26 peut être interposée entre des première et deuxième couches d'interface, non représentées. Suivant le mode de polarisation de la photodiode, les couches d'interface facilitent la collection, l'injection ou le blocage des charges depuis les électrodes dans la couche active 26. L'épaisseur de chaque couche d'interface est de préférence comprise entre 0,1 nm et 1 µm. La première couche d'interface permet d'aligner le travail de sortie de l'électrode adjacente avec l'affinité électronique du matériau accepteur utilisé dans la couche active 26. La première couche d'interface peut être réalisée en carbonate de césium (CSCO₃), en oxyde métallique, notamment en oxyde de zinc (ZnO), ou en un mélange d'au moins deux de ces composés. La première couche d'interface peut comprendre une couche monomoléculaire auto-assemblée ou un polymère, par exemple du polyéthyléneimine, polyéthyléneimine éthoxylé, poly[(9,9-bis(3'-(N,N-dimethylamino) propyl)-2,7-fluorene)-alt-2,7-(9,9-dioctylfluorene)]. La deuxième couche d'interface permet d'aligner le travail de sortie de l'autre électrode avec le potentiel d'ionisation du matériau donneur utilisé dans la couche active 26. La deuxième couche d'interface peut être réalisée en oxyde de cuivre (CuO), en oxyde de nickel (NiO), en oxyde de vanadium (V₂O₅), en oxyde de magnésium (MgO), en oxyde de tungstène (WO₃), en oxyde de molybdène (MoO₃), en PEDOT:PSS ou en un mélange d'au moins deux de ces composés.

Les microlentilles 36 sont de taille micrométrique. Dans le présent mode de réalisation, chaque sous-pixel SPix comprend une microlentille 36. A titre de variante, chaque microlentille 36 peut être remplacée par un autre type d'élément optique de taille micrométrique, notamment une lentille de Fresnel de taille micrométrique, une lentille à gradient d'indice de taille micrométrique ou un réseau de diffraction de taille micrométrique. Les microlentilles 36 sont des lentilles convergentes ayant chacune une distance focale f comprise entre 1 µm et 100 µm, de préférence entre 1 µm et 10 µm. Selon un mode de réalisation, toutes les microlentilles 36 sont sensiblement identiques.

Les microlentilles 36 peuvent être réalisées en silice, en PMMA, en une résine photosensible positive, en PET, en PEN, en COP, en PDMS/silicone, ou en résine époxy. Les microlentilles 36 peuvent être formées par fluage de blocs d'une résine photosensible. Les microlentilles 36 peuvent en outre être formées par moulage sur une couche de PET, PEN, COP, PDMS/silicone ou résine époxy.

Selon un mode de réalisation, la couche 38 est une couche qui épouse la forme des microlentilles 36. La couche 38 peut être obtenue à partir d'un adhésif optiquement transparent (OCA, sigle anglais pour Optically Clear Adhesive), notamment un adhésif optiquement transparent liquide (LOCA, sigle anglais pour Liquid Optically Clear Adhesive), ou un matériau à bas indice de réfraction, ou une colle époxy/acrylate, ou un film d'un gaz ou d'un mélange gazeux, par exemple de l'air. De préférence, lorsque la couche 38 épouse la forme des microlentilles 36, la couche 38 est en un matériau ayant un bas indice de réfraction, inférieur à celui du matériau des microlentilles 36. La couche 38 peut être en un matériau de remplissage qui est un matériau transparent non adhésif. Selon un autre mode de réalisation, la couche 38 correspond à un film qui est appliqué contre la matrice de microlentilles 36, par exemple un film OCA. Dans ce cas, la zone de contact entre la couche 38 et les microlentilles 36 peut être réduite, par exemple limitée aux sommets des microlentilles. La couche 38 peut être alors composée d'un matériau ayant un indice de réfraction plus élevé que dans le cas où la couche 38 épouse les microlentilles 36. Selon un autre mode de réalisation, la couche 38 correspond à un film OCA qui est appliqué contre la matrice de microlentilles 36, l'adhésif ayant des propriétés qui permettent au film 38 d'épouser complètement ou sensiblement complètement la surface des microlentilles.

Selon les matériaux considérés, le procédé de formation d'au moins certaines couches du capteur d'images 1 peut correspondre à un procédé dit additif, par exemple par impression directe du matériau composant les couches organiques aux emplacements souhaités notamment sous forme de sol-gel, par exemple par impression par jet d'encre, héliographie, sérigraphie, flexographie, revêtement par pulvérisation (en anglais spray coating) ou dépôt de gouttes (en anglais drop-casting). Selon les matériaux considérés, le procédé de formation des couches du capteur d'images 1 peut correspondre à un procédé dit soustractif, dans lequel le matériau composant les couches organiques est déposé sur la totalité de la structure et dans lequel les portions non utilisées sont ensuite retirées, par exemple par photolithographie ou ablation laser. En outre, selon les couches et les matériaux considérés, le matériau composant la couche active 26 est déposé sur la totalité de la structure et n'est pas partiellement retiré, le pas des photodiodes étant alors obtenu par la position des électrodes 22 et 28. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Lorsque les couches sont métalliques, le métal est, par exemple, déposé par évaporation ou par pulvérisation cathodique sur l'ensemble du support et les couches métalliques sont délimitées par gravure.

De façon avantageuse, au moins certaines des couches du capteur d'images 1 peuvent être réalisées par des techniques d'impression. Les matériaux de ces couches décrites précédemment peuvent être déposés sous forme liquide, par exemple sous forme d'encres conductrices et semiconductrices à l'aide d'imprimantes à jet d'encre. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150°C, et le dépôt et les éventuels recuits peuvent être réalisés à la pression atmosphérique.

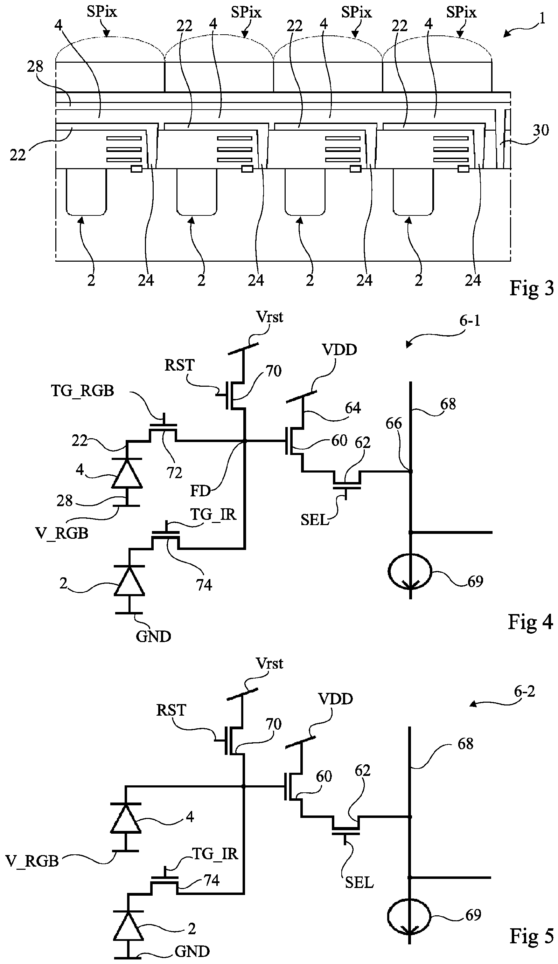

La figure 3 est une vue en coupe du capteur d'images 1 illustrant un autre mode de réalisation d'agencement des électrodes des photodiodes couleur 4. Dans le présent mode de réalisation, l'électrode 28 est commune à chaque photodiode couleur 4 du pixel. En outre, l'électrode 28 peut être commune à l'ensemble des pixels d'une même rangée de pixels. Le via 30 peut alors ne pas être présent pour chaque sous-pixel du pixel et être prévu dans des zones ne correspondant pas à des sous-pixels, par exemple à la périphérie du pixel. Seule l'électrode 22 est délimitée pour chaque sous-pixel SPix.

La figure 4 représente le schéma électrique simplifié d'un mode de réalisation du circuit de lecture 6-1 associé à la photodiode couleur 4 et à la photodiode infrarouge 2 d'un sous-pixel SPix.

Le circuit de lecture 6-1 comporte un transistor MOS en montage suiveur 60, en série avec un transistor MOS de sélection 62, entre deux bornes 64, 66. La borne 64 est reliée à une source d'un potentiel de référence haut VDD dans le cas où les transistors composant le circuit de lecture sont des transistors MOS à canal N, ou d'un potentiel de référence bas, par exemple la masse, dans le cas où les transistors composant le circuit de lecture sont des transistors MOS à canal P. La borne 66 est reliée à une piste conductrice 68. La piste conductrice 68 peut être reliée à tous les sous-pixels d'une même colonne et être reliée à une source de courant 69 qui ne fait pas partie du circuit de lecture 6-1 du sous-pixel. La grille du transistor 62 est destinée à recevoir un signal SEL de sélection du sous-pixel. La grille du transistor 60 est reliée à un noeud FD. Le noeud FD est relié, par un transistor MOS 70 de réinitialisation, à une borne d'application d'un potentiel Vrst de réinitialisation, ce potentiel pouvant être VDD. La grille du transistor 70 est destinée à recevoir un signal RST de commande en réinitialisation du sous-pixel, permettant notamment de réinitialiser le noeud FD sensiblement au potentiel Vrst.

Le noeud FD est relié à l'électrode de cathode 22 de la photodiode couleur 4 du sous-pixel considéré par l'intermédiaire d'un transistor MOS de transfert 72. L'électrode d'anode 28 de la photodiode couleur 4 du sous-pixel est reliée à une source d'un potentiel de référence V_RGB. La grille du transistor 72 est destinée à recevoir un signal TG_RGB de sélection de la photodiode couleur 4 du sous-pixel. La grille du transistor 60 est en outre reliée à l'électrode de cathode de la photodiode infrarouge 2 du sous-pixel considéré par l'intermédiaire d'un transistor MOS de transfert 74. L'électrode d'anode de la photodiode infrarouge 2 du sous-pixel est reliée à une source d'un potentiel de référence bas GND, par exemple la masse. La grille du transistor 74 est destinée à recevoir un signal TG_IR de sélection de la photodiode infrarouge 2 du sous-pixel. Dans le présent mode de réalisation, le circuit de lecture 6-1 représenté en figure 4 comprenant cinq transistors MOS est prévu pour chaque sous-pixel. Pour chaque rangée de sous-pixels, les signaux SEL, TR_RGB, TR_IR, RST et le potentiel V_RGB peuvent être transmis à tous les sous-pixels de la rangée. On appelle V_FD le potentiel au noeud FD référencé par rapport au potentiel de référence bas GND. Il peut être prévu un condensateur, non représenté, dont une électrode est reliée au noeud FD et dont l'autre électrode est reliée à la source du potentiel de référence bas GND. A titre de variante, le rôle de ce condensateur peut être rempli par les capacités parasites présentes au noeud FD.

La figure 5 représente le schéma électrique simplifié d'un autre mode de réalisation du circuit de lecture 6-2 associé à la photodiode couleur 4 et à la photodiode infrarouge 2 d'un sous-pixel. Le circuit de lecture 6-2 comprend tous les éléments du circuit de lecture 6-1 représenté en figure 4 à la différence que le transistor de transfert 72 n'est pas présent, l'électrode de cathode 22 étant directement reliée à la grille du transistor 60 monté en suiveur.

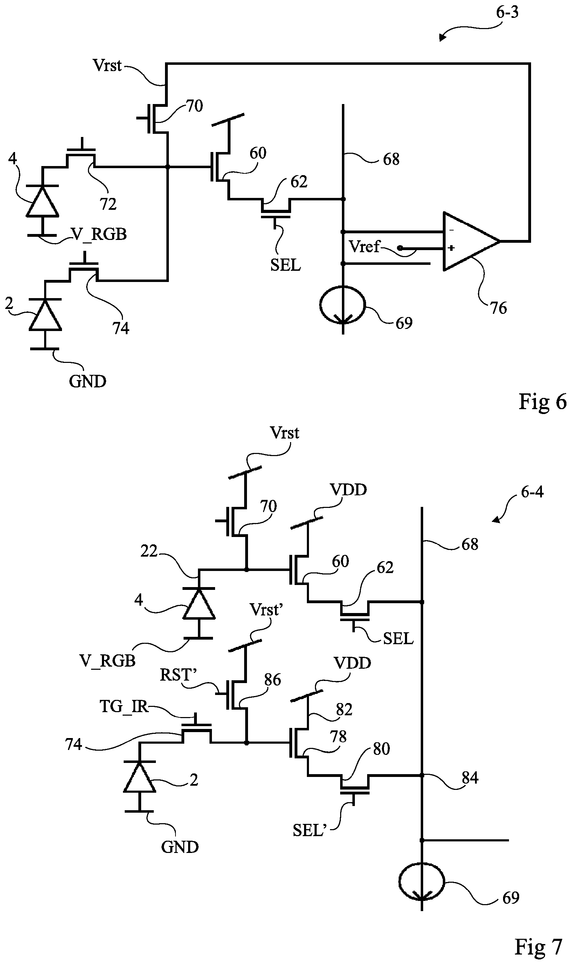

La figure 6 représente le schéma électrique simplifié d'un autre mode de réalisation du circuit de lecture 6-3 associé à la photodiode couleur 4 et à la photodiode infrarouge 2 d'un sous-pixel. Le circuit de lecture 6-3 comprend tous les éléments du circuit de lecture 6-1 représenté en figure 4 et comprend en outre, pour chaque piste conductrice 68, un amplificateur opérationnel 76 dont l'entrée inverseuse (-) est reliée à la piste conductrice 68, dont l'entrée non inverseuse (+) est reliée à une source d'un potentiel de référence Vref et dont la sortie fournit le potentiel Vrst appliqué à l'une des bornes de puissance du transistor de réinitialisation 70. L'amplificateur opérationnel 76 peut être relié à tous les transistors de réinitialisation 70 des sous-pixels reliés à la piste conductrice 68. L'amplificateur opérationnel 76 forme une boucle de rétroaction qui permet de réduire, voire de supprimer, le bruit thermique du transistor de réinitialisation 70, ce bruit étant habituellement supprimé par un procédé de lecture mettant en oeuvre un double échantillonnage corrélé (CDS, sigle anglais pour Correlated Double Sampling).

La figure 7 représente le schéma électrique simplifié d'un autre mode de réalisation du circuit de lecture 6-4 associé à la photodiode couleur 4 et à la photodiode infrarouge 2 d'un sous-pixel. Le circuit de lecture 6-4 comprend tous les éléments du circuit de lecture 6-1 représenté en figure 4 à la différence que le transistor MOS de transfert 72 n'est pas présent, que l'électrode de cathode 22 de la photodiode couleur 4 est connectée à la grille du transistor en montage suiveur 60 et que le circuit de lecture 6-4 comprend, en outre, un transistor MOS en montage suiveur 78, en série avec un transistor MOS de sélection 80, entre deux bornes 82, 84. La borne 82 est reliée à la source du potentiel de référence haut VDD. La borne 84 est reliée à la piste conductrice 68. La grille du transistor 80 est destinée à recevoir un signal SEL' de sélection de la photodiode infrarouge 2. La grille du transistor 78 est reliée, par un transistor MOS 86 de réinitialisation, à une borne d'application du potentiel Vrst de réinitialisation. La grille du transistor 86 est destinée à recevoir un signal RST' de commande en réinitialisation de la photodiode infrarouge 2 permettant de recharger la photodiode 2 en appliquant un potentiel Vrst à la cathode de la photodiode infrarouge. La grille du transistor 78 est reliée au transistor de transfert 74.

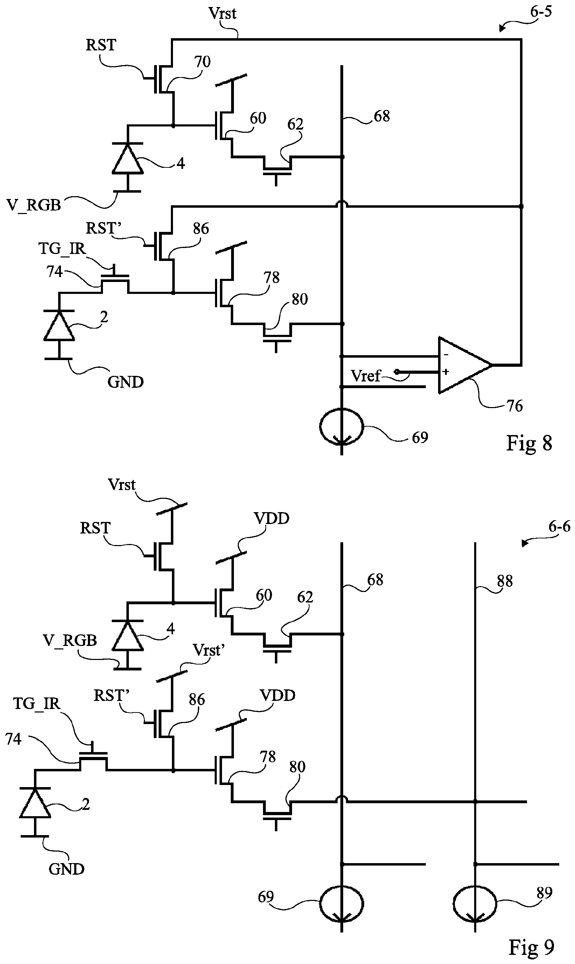

La figure 8 représente le schéma électrique simplifié d'un autre mode de réalisation du circuit de lecture 6-5 associé à la photodiode couleur 4 et à la photodiode infrarouge 2 d'un sous-pixel. Le circuit de lecture 6-5 comprend tous les éléments du circuit de lecture 6-4 représenté en figure 7 et comprend en outre l'amplificateur opérationnel 76 du circuit de lecture 6-3 représenté en figure 6 dont l'entrée inverseuse (-) est reliée à la piste conductrice 68, dont l'entrée non inverseuse (+) est reliée à la source d'un potentiel de référence Vref et dont la sortie fournit le potentiel Vrst appliqué à l'une des bornes de puissance des transistors de réinitialisation 70 et 86.

La figure 9 représente le schéma électrique simplifié d'un autre mode de réalisation du circuit de lecture 6-6 associé à la photodiode couleur 4 et à la photodiode infrarouge 2 d'un sous-pixel. Le circuit de lecture 6-6 comprend tous les éléments du circuit de lecture 6-4 représenté en figure 7, à la différence que le transistor de sélection 80 est relié à une piste conductrice 88, différente de la piste conductrice 68, et qui est reliée à une source de courant 89. Dans le présent mode de réalisation, les sous-pixels de couleur et les sous-pixels infrarouges ne sont donc pas reliés en colonnes. Ceci permet de mettre en oeuvre des procédés de lecture différents, notamment par les durées des étapes successives du procédé, pour les pixels couleur et les pixels infrarouges.

De façon générale, les potentiels de réinitialisation Vrst, Vrst' peuvent être communs à tous les pixels. Le potentiel Vrst est alors égal au potentiel Vrst'. A titre de variante, les potentiels de réinitialisation peuvent être différenciés en fonction de la colonne sur laquelle les pixels correspondants sont lus.

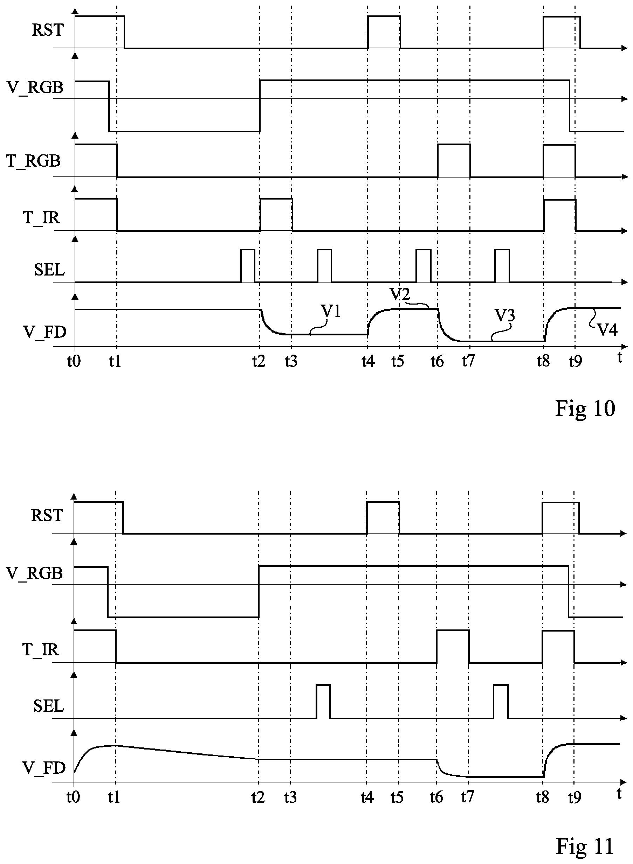

La figure 10 est un chronogramme des signaux binaires RST, TG_IR, TG_RGB et SEL, et des potentiels V_RGB et V_FD au cours d'un mode de réalisation d'un procédé de fonctionnement du capteur d'images 6-1 représenté en figure 4. On appelle t0 à t9 des instants successifs d'un cycle de fonctionnement. Le chronogramme a été établi en considérant que les transistors MOS du circuit de lecture 6-1 sont des transistors à canal N.

A l'instant t0, le signal SEL est à l'état bas de sorte que le transistor de sélection 62 est bloqué. Le cycle comprend une phase de réinitialisation. Dans ce but, le signal RST est à l'état haut de sorte que le transistor de réinitialisation 70 est passant. Le signal TG_IR est à l'état haut de sorte que le transistor de transfert 74 est passant. Les charges accumulées dans la photodiode infrarouge 2 sont alors évacuées vers la source du potentiel Vrst. De façon analogue, le signal TG_RGB est à l'état haut de sorte que le transistor de transfert 72 est passant. La photodiode couleur 4 est rechargée en injectant des charges via la source de potentiel Vrst.

Juste avant l'instant t1, le potentiel V_RGB est mis à un niveau bas. A l'instant t1, qui marque le début d'un nouveau cycle, le signal TG_IR est mis à l'état bas de sorte que le transistor de transfert 74 est bloqué et le signal TG_RGB est mis à l'état bas de sorte que le transistor de transfert 72 est bloqué. Une phase d'intégration débute alors pendant laquelle des charges sont générées dans les photodiodes 2 et 4. Juste après l'instant t1, le signal RST est mis à l'état bas de sorte que le transistor de réinitialisation 70 est bloqué. Le potentiel V_FD est alors fixé à une première valeur V1. Entre les instants t1 et t2, le signal SEL est mis temporairement à un état haut, de sorte que le potentiel de la piste conductrice 68 atteint une valeur représentative de V1 qui est mémorisée.

A l'instant t2, le potentiel V_RGB est mis à un niveau haut, ce qui stoppe la collecte de charges dans la photodiode couleur 4. Entre les instants t2 et t3, le signal TG_IR est mis à l'état haut de sorte que le transistor de transfert 74 est passant. Les charges stockées dans la photodiode infrarouge 2 sont alors transférées vers le noeud FD dont le potentiel V_FD diminue jusqu'à une valeur V2. Entre les instants t3 et t4, le signal SEL est temporairement mis à l'état haut, de sorte que le potentiel de la piste conductrice 68 atteint une valeur représentative de V2 qui est mémorisée. La différence entre les valeurs V2 et V1 est représentative de la quantité de charges collectées dans la photodiode infrarouge 2 pendant la phase d'intégration.

Entre les instants t4 et t5, le signal RST est mis à l'état haut de sorte que le transistor de réinitialisation 70 est passant. Le potentiel V_FD se stabilise alors sensiblement à une valeur V3. Entre les instants t5 et t6, le signal SEL est temporairement mis à l'état haut, de sorte que le potentiel de la piste conductrice 68 atteint une valeur représentative de V3 qui est mémorisée. Entre les instants t6 et t7, le signal TG_RGB est mis à l'état haut de sorte que le transistor de transfert 72 est passant. Les charges collectées dans la photodiode couleur 4 sont alors transférées vers le noeud FD dont le potentiel V_FD diminue jusqu'à une valeur V4. Entre les instants t7 et t8, le signal SEL est temporairement mis à l'état haut, de sorte que le potentiel de la piste conductrice 68 atteint une valeur représentative de V4 qui est mémorisée. La différence entre les valeurs V4 et V3 est représentative de la quantité de charges stockées dans la photodiode couleur 4 pendant la phase d'intégration. L'instant t9 marque la fin du cycle et correspond à l'instant t1 du cycle suivant. Dans le présent mode de réalisation, la durée de la phase d'intégration de la photodiode infrarouge 2 est commandée par le transistor de transfert 74 tandis que la durée de la phase d'intégration de la photodiode couleur 4 est commandée par le potentiel V_RGB. Dans le présent mode de réalisation, la phase d'intégration de la photodiode couleur 4 a la même durée que la phase d'intégration de la photodiode infrarouge 2.

Le présent mode de réalisation permet de façon avantageuse de réaliser un procédé de lecture de type Global Shutter pour l'acquisition de l'image couleur, dans lequel les phases d'intégration de toutes les photodiodes couleur sont réalisées de façon simultanée, et un procédé de lecture de type Global Shutter pour l'acquisition de l'image infrarouge, dans lequel les phases d'intégration de toutes les photodiodes infrarouges sont réalisées de façon simultanée.

La figure 11 est un chronogramme des signaux binaires RST, TG_IR, TG_RGB et SEL, et des potentiels V_RGB et V_FD au cours d'un autre mode de réalisation d'un procédé de fonctionnement du capteur d'images 6-1 représenté en figure 5. Par rapport au chronogramme représenté en figure 10, le signal T_IR en figure 11 varie comme le signal T_RGB en figure 10 et le signal T_RGB n'est pas présent en figure 11. Dans le présent mode de réalisation, la durée de la phase d'intégration de la photodiode infrarouge 2 est commandée par le transistor de transfert 74 tandis que la durée de la phase d'intégration de la photodiode couleur 4 est commandée par le potentiel V_RGB. La lecture est réalisée en deux étapes. Une première étape de lecture est réalisée entre les instants t3 et t4 où la valeur de la photodiode couleur 4 est lue et une deuxième étape de lecture est réalisée entre les instants t7 et t8 où la somme de la valeur de la photodiode couleur 4 et de la valeur de la photodiode infrarouge 2 est lue. La valeur de la photodiode infrarouge 2 est obtenue par une opération de soustraction des deux valeurs lues. Dans le présent mode de réalisation, la phase d'intégration de la photodiode couleur 4 est plus courte que la phase d'intégration de la photodiode infrarouge 2. Le présent mode de réalisation permet de façon avantageuse de réaliser un procédé de lecture de type Global Shutter pour l'acquisition de l'image couleur, dans lequel les phases d'intégration de toutes les photodiodes couleur sont réalisées de façon simultanée, et un procédé de lecture de type Global Shutter pour l'acquisition de l'image infrarouge, dans lequel les phases d'intégration de toutes les photodiodes infrarouges sont réalisées de façon simultanée.

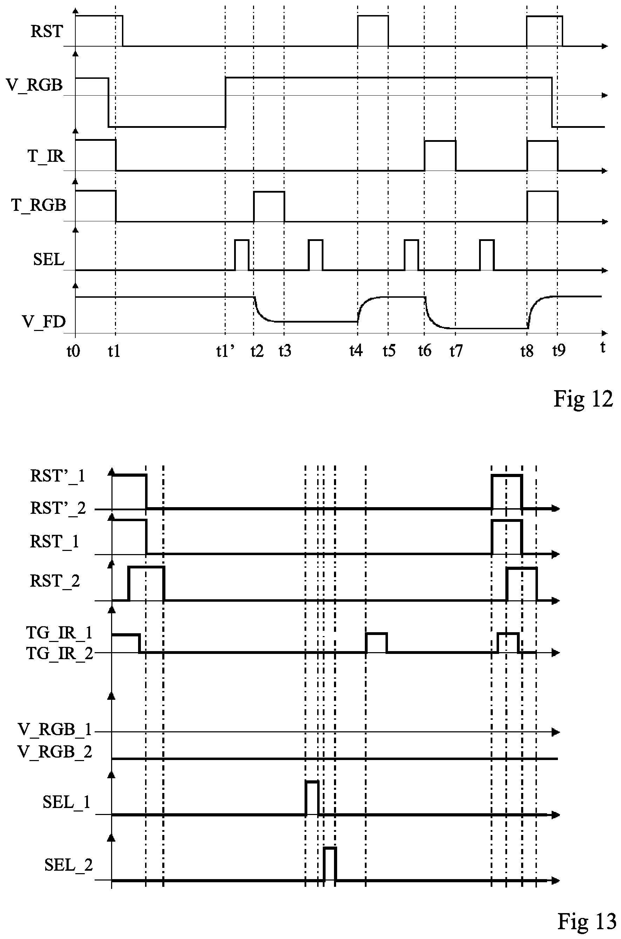

La figure 12 est un chronogramme des signaux binaires RST, TG_IR, TG_RGB et SEL, et des potentiels V_RGB et V_FD au cours d'un autre mode de réalisation d'un procédé de fonctionnement du capteur d'images 6-1 représenté en figure 4. Le présent cycle de fonctionnement comprend la même succession de phases que le cycle de fonctionnement illustré en figure 10, à la différence que le potentiel V_RGB reste à l'état bas jusqu'à un instant t1', situé dans le présent mode de réalisation entre les instants t1 et t2.

Dans le présent mode de réalisation, pour chaque sous-pixel, la phase d'intégration de la photodiode infrarouge 2 s'étend de l'instant t1 à l'instant t2 et la phase d'intégration de la photodiode couleur 4 s'étend de l'instant t1 à l'instant t1'. Le présent mode de réalisation permet que la durée de la phase d'intégration de la photodiode infrarouge soit différente de la durée de phase d'intégration de la photodiode couleur. En outre, le présent mode de réalisation permet de façon avantageuse de réaliser un procédé de lecture de type Global Shutter pour l'acquisition de l'image couleur et un procédé de lecture de type Global Shutter pour l'acquisition de l'image infrarouge.

La figure 13 est un chronogramme des signaux RST'_1, RST'_2, RST_1, RST_2, SEL_1, SEL_2 et des potentiels V_RGB_1 et V_RGB_2 au cours d'un autre mode de réalisation d'un procédé de fonctionnement du capteur d'images 6-6 représenté en figure 9 en considérant des première et deuxième rangées successives de pixels, les signaux et potentiels associés à la première rangée de pixels comprenant le suffixe "_1" et les signaux et potentiels associés à la deuxième rangée de pixels comprenant le suffixe "_2".

Comme cela apparaît sur la figure 13, les signaux V_RGB_1 et V_RGB_2 sont maintenus en permanence au niveau bas. Les phases d'intégration des photodiodes infrarouges des deux rangées commandées par les signaux TG_IR_1 et TG_IR_2 sont réalisées de façon simultanée tandis que la phase d'intégration de la photodiode couleur de la première rangée commandée par les signaux RST_1 et SEL_1 est décalée dans le temps par rapport à la phase d'intégration de la photodiode couleur de la deuxième rangée commandée par les signaux RST_2 et SEL_2. Ceci permet de mettre en oeuvre un procédé de lecture du type Global Shutter pour les photodiodes infrarouges et un procédé de lecture du type à "obturateur déroulant" (en anglais Rolling Shutter) pour les photodiodes couleur dans lequel les phases d'intégration des lignes de pixels sont décalées dans le temps les unes par rapport aux autres.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les circuits de lecture représentés sur les figures 5 à 8 peuvent être mis en oeuvre avec l'une quelconque des structures de sous-pixels représentées sur les figures 2 et 3. En outre, les chronogrammes décrits précédemment en relation avec les figures 9 et 10 peuvent en outre être mis en oeuvre avec les circuits de lecture représentés sur les figures 5 à 8. Enfin, la mise en oeuvre pratique des modes de réalisation et variantes décrits est à la portée de l'homme du métier à partir des indications fonctionnelles données ci-dessus.

## Revendications

1. Capteur (1) d'images couleur et infrarouge comprenant un substrat (10) en silicium, des transistors MOS (16 ; 60, 62, 70, 72, 74) formés dans le substrat et sur le substrat, des premières photodiodes (2) formées au moins en partie dans le substrat, une couche photosensible (26) recouvrant le substrat et des filtres de couleur (34), la couche photosensible étant interposée entre le substrat et les filtres de couleur, le capteur d'images comprenant en outre des premières et deuxièmes électrodes (22, 28) de part et d'autre de la couche photosensible et délimitant des deuxièmes photodiodes (4) dans la couche photosensible, les premières photodiodes étant configurées pour absorber les ondes électromagnétiques du spectre visible et d'une première partie du spectre infrarouge et la couche photosensible étant configurée pour absorber les ondes électromagnétiques du spectre visible et pour laisser passer les ondes électromagnétiques de ladite première partie du spectre infrarouge, le capteur d'images comprenant, pour chaque pixel de l'image couleur à acquérir, au moins des premier, deuxième et troisième sous-pixels (SPix) comprenant chacun l'une des deuxièmes photodiodes (4), l'une des premières photodiodes (2), et l'un des filtres de couleur (34), les filtres de couleur des premier, deuxième et troisième sous-pixels laissant passer les ondes électromagnétiques dans des plages de fréquences différentes du spectre visible, le capteur d'images comprenant, pour chaque pixel de l'image couleur à acquérir, au moins un quatrième sous-pixel (SPix) comprenant l'une des deuxièmes photodiodes (4) et l'un des filtres de couleur (34), le filtre de couleur du quatrième sous-pixel étant configuré pour bloquer les ondes électromagnétiques du spectre visible et pour laisser passer les ondes électromagnétiques dans une troisième partie du spectre infrarouge entre le spectre visible et la première partie du spectre infrarouge, la couche photosensible (26) étant configurée pour absorber les ondes électromagnétiques dans ladite troisième partie du spectre infrarouge.

2. Capteur d'images selon la revendication 1, comprenant en outre un filtre infrarouge (40), les filtres de couleur (34) étant interposés entre la couche photosensible (26) et le filtre infrarouge, le filtre infrarouge étant configuré pour laisser passer les ondes électromagnétiques du spectre visible, pour laisser passer les ondes électromagnétiques de ladite première partie du spectre infrarouge et pour bloquer les ondes électromagnétiques d'au moins une deuxième partie du spectre infrarouge entre le spectre visible et la première partie du spectre infrarouge.

3. Capteur d'images selon la revendication 2, comprenant une matrice de lentilles (36) interposée entre la couche photosensible (26) et le filtre infrarouge (50).

4. Capteur d'images selon l'une quelconque des revendications 1 à 3, dans lequel, pour chaque pixel de l'image couleur à acquérir, la deuxième électrode (28) est commune aux premier, deuxième et troisième sous-pixels (SPix).

5. Capteur d'images selon l'une quelconque des revendications 1 à 4, comprenant, pour chaque premier, deuxième et troisième sous-pixel (SPix), un circuit de lecture (6-2) relié à la deuxième photodiode (4) et à la première photodiode (2).

6. Capteur d'images selon la revendication 5, dans lequel le circuit de lecture (6-2) est configuré pour transférer des premières charges électriques générées dans la première photodiode (2) vers une première piste conductrice électriquement (68 ; 88) et configuré pour transférer des deuxièmes charges générées dans la deuxième photodiode (4) vers la première piste conductrice électriquement (68) ou une deuxième piste conductrice électriquement.

7. Capteur d'images selon la revendication 6, dans lequel les premières photodiodes (2) sont agencées en rangées et en colonnes et dans lequel les circuits de lecture (6-2) sont configurés pour commander la génération des premières charges pendant des premiers intervalles de temps simultanés pour toutes les premières photodiodes (2) du capteur d'images.

8. Capteur d'images selon la revendication 6 ou 7, dans lequel les deuxièmes photodiodes (4) sont agencées en rangées et en colonnes et dans lequel les circuits de lecture (6-2) sont configurés pour commander la génération des deuxièmes charges pendant des deuxièmes intervalles de temps simultanés pour toutes les deuxièmes photodiodes du capteur d'images ou décalés dans le temps d'une rangée de deuxièmes photodiodes à l'autre.

9. Capteur d'images selon l'une quelconque des revendications 6 à 8, dans lequel les circuits de lecture (6-2) sont configurés pour commander une première phase d'intégration pour les premières photodiodes (2) ayant une première durée et pour commander une deuxième phase d'intégration pour les deuxièmes photodiodes (4) ayant une deuxième durée différente de la première durée.

10. Capteur d'images selon l'une quelconque des revendications 6 à 9, dans lequel chaque circuit de lecture (6-2) comprend au moins un premier transistor MOS (60) monté en suiveur, la deuxième photodiode (4) ayant une première électrode (22) reliée directement à la grille du premier transistor MOS et la deuxième photodiode (2) ayant une deuxième électrode reliée à la grille du premier transistor MOS, ou à la grille d'un deuxième transistor MOS (78) monté en suiveur, par l'intermédiaire d'un troisième transistor MOS (74) .

11. Capteur d'images selon l'une quelconque des revendications 1 à 10, dans lequel la couche photosensible (26) est en matériaux organiques et/ou contient des boîtes quantiques.

## Patentansprüche

1. Farb- und Infrarot-Bildsensor (1) aufweisend ein Siliziumsubstrat (10), MOS-Transistoren (16; 60, 62, 70, 72, 74), die in Substrat und auf dem Substrat ausgebildet sind, erste Fotodioden (2), die zumindest teilweise in dem Substrat ausgebildet sind, eine lichtempfindliche Schicht (26), die das Substrat bedeckt, und Farbfilter (34), wobei die lichtempfindliche Schicht zwischen dem Substrat und den Farbfiltern angeordnet ist, wobei der Bildsensor ferner erste und zweite Elektroden (22, 28) aufweist, die auf jeder Seite der lichtempfindlichen Schicht vorgesehen sind und zweite Fotodioden (4) in der lichtempfindlichen Schicht begrenzen, wobei die ersten Fotodioden konfiguriert sind zum Absorbieren von elektromagnetischen Wellen des sichtbaren Spektrums und eines ersten Teils des Infrarotspektrums, und wobei die lichtempfindliche Schicht konfiguriert ist zum Absorbieren von elektromagnetischen Wellen des sichtbaren Spektrums und zum Durchlassen von elektromagnetischen Wellen des ersten Teils des Infrarotspektrums, wobei der Bildsensor für jedes Pixel des zu erfassenden Farbbildes mindestens ein erstes, zweites und drittes Teilpixel aufweist, die jeweils eine der zweiten Fotodioden (4), eine der ersten Fotodioden (2) und einen der Farbfilter (34) aufweisen, wobei die Farbfilter des ersten, des zweiten und des dritten Teilterpixels elektromagnetische Wellen in verschiedenen Frequenzbereichen des sichtbaren Spektrums durchlassen, wobei der Bildsensor für jedes Pixel des zu erfassenden Farbbildes mindestens ein viertes Teilpixel (SPix) aufweist, das eine der zweiten Fotodioden (4) und einen der Farbfilter (34) aufweist, wobei der Farbfilter des vierten Teilpixels konfiguriert ist zum Blockieren von elektromagnetischen Wellen des sichtbaren Spektrums und zum Durchlassen von elektromagnetischen Wellen in einem dritten Teil des Infrarotspektrums zwischen dem sichtbaren Spektrum und dem ersten Teil des Infrarotspektrums, wobei die lichtempfindliche Schicht (26) konfiguriert ist zum Absorbieren von elektromagnetischen Wellen in dem dritten Teil des Infrarotspektrums.

2. Bildsensor nach Anspruch 1, der ferner einen Infrarotfilter (40) aufweist, wobei die Farbfilter (34) zwischen der lichtempfindlichen Schicht (26) und dem Infrarotfilter angeordnet sind, wobei der Infrarotfilter konfiguriert ist zum Durchlassen von elektromagnetischen Wellen des sichtbaren Spektrums, zum Durchlassen von elektromagnetischen Wellen des ersten Teils des Infrarotspektrums und zum Blockieren von elektromagnetischen Wellen mindestens eines zweiten Teils des Infrarotspektrums zwischen dem sichtbaren Spektrum und dem ersten Teil des Infrarotspektrums.

3. Bildsensor nach Anspruch 2, aufweisend eine Anordnung von Linsen (36), die zwischen der lichtempfindlichen Schicht (26) und dem Infrarotfilter (50) angeordnet sind.

4. Bildsensor nach einem der Ansprüche 1 bis 3, wobei für jedes Pixel des zu erfassenden Farbbildes die zweite Elektrode (28) dem ersten, zweiten und dritten Teilpixel (SPix) gemeinsam ist.

5. Bildsensor nach einem der Ansprüche 1 bis 4, der für jedes erste, zweite und dritte Teilpixel (SPix) eine Ausleseschaltung (6-2) aufweist, die mit der zweiten Fotodiode (4) und der ersten Fotodiode (2) verbunden ist.

6. Bildsensor nach Anspruch 5, wobei die Ausleseschaltung (6-2) konfiguriert ist zum Senden erster elektrischer Ladungen, die in der ersten Fotodiode (2) erzeugt werden, zu einer erste elektrisch leitenden Bahn (68; 88) und konfiguriert ist zum Senden zweiter Ladungen, die in der zweiten Fotodiode (4) erzeugt werden, zu der ersten elektrisch leitenden Bahn (68) oder zu einer zweiten elektrisch leitenden Bahn.

7. Bildsensor nach Anspruch 6, wobei die ersten Fotodioden (2) in Zeilen und in Spalten angeordnet sind und wobei die Ausleseschaltungen (6-2) konfiguriert sind zum Steuern der Erzeugung der ersten Ladungen während erster Zeitintervalle gleichzeitig für alle ersten Fotodioden (2) des Bildsensors.

8. Bildsensor nach Anspruch 6 oder 7, wobei die zweiten Fotodioden (4) in Zeilen und in Spalten angeordnet sind und wobei die Ausleseschaltungen (6-2) konfiguriert ist zum Steuern der Erzeugung der zweiten Ladungen während zweiter Zeitintervalle gleichzeitig für alle zweiten Fotodioden des Bildsensors oder zeitlich verschoben von einer Zeile der zweiten Fotodioden zu einer Anderen.

9. Bildsensor nach einem der Ansprüche 6 bis 8, wobei die Ausleseschaltungen (6-2) konfiguriert ist zum Steuern einer ersten Integrationsphase für die ersten Fotodioden (2) mit einer ersten Dauer und zum Steuern einer zweiten Integrationsphase für die zweiten Fotodioden (4) mit einer zweiten Dauer, die sich von der ersten Dauer unterscheidet.

10. Bildsensor nach einem der Ansprüche 6 bis 9, wobei jede Ausleseschaltung (6-2) mindestens einen ersten als Spannungsfolger montierten MOS-Transistor (60) aufweist, wobei die zweite Fotodiode (4) eine erste Elektrode (22) aufweist, die direkt mit dem Gate des ersten MOS-Transistors gekoppelt ist, und die zweite Fotodiode (2) eine zweite Elektrode aufweist, die über einen dritten MOS-Transistor (74) mit dem Gate des ersten MOS-Transistors oder mit dem Gate eines zweiten als Spannungsfolger montierten MOS-Transistors (78) gekoppelt ist.

11. Bildsensor nach einem der Ansprüche 1 bis 10, wobei die lichtempfindliche Schicht (26) aus organischen Materialien hergestellt ist und/oder Quantenpunkte enthält.

## Claims

1. A color and infrared image sensor (1) comprising a silicon substrate (10), MOS transistors (16; 60, 62, 70, 72, 74) formed in the substrate and on the substrate, first photodiodes (2) at least partly formed in the substrate, a photosensitive layer (26) covering the substrate, and color filters (34), the photosensitive layer being interposed between the substrate and the color filters, the image sensor further comprising first and second electrodes (22, 28) on either side of the photosensitive layer and delimiting second photodiodes (4) in the photosensitive layer, the first photodiodes being configured to absorb the electromagnetic waves of the visible spectrum and of a first portion of the infrared spectrum and the photosensitive layer being configured to absorb the electromagnetic waves of the visible spectrum and to give way to the electromagnetic waves of said first portion of the infrared spectrum, the image sensor comprising, for each pixel of the color image to be acquired, at least first, second, and third sub-pixels (SPix) each comprising one of the second photodiodes (4), one of the first photodiodes (2), and one of the color filters (34), the color filters of the first, second, and third sub-pixels giving way to electromagnetic waves in different frequency ranges of the visible spectrum, the image sensor comprising, for each pixel of the color image to be acquired, at least one fourth sub-pixel (SPix) comprising one of the second photodiodes (4) and one of the color filters (34), the color filter of the fourth sub-pixel being configured to block the electromagnetic waves of the visible spectrum and to give way to electromagnetic waves in a third portion of the infrared spectrum between the visible spectrum and the first portion of the infrared spectrum, the photosensitive layer (26) being configured to absorb electromagnetic waves in said third portion of the infrared spectrum.

2. The image sensor according to claim 1, further comprising an infrared filter (40), the color filters (34) being interposed between the photosensitive layer (26) and the infrared filter, the infrared filter being configured to give way to the electromagnetic waves of the visible spectrum, to give way to the electromagnetic waves of said first portion of the infrared spectrum, and to block the electromagnetic waves of at least a second portion of the infrared spectrum between the visible spectrum and the first portion of the infrared spectrum.

3. The image sensor according to claim 2, comprising an array of lenses (36) interposed between the photosensitive layer (26) and the infrared filter (50).

4. The image sensor according to any of claims 1 to 3, wherein, for each pixel of the color image to be acquired, the second electrode (28) is common to the first, second, and third sub-pixels (SPix).

5. The image sensor according to any of claims 1 to 4, comprising, for each first, second, and third sub-pixels (SPix), a readout circuit (6-2) coupled to the second photodiode (4) and to the first photodiode (2).

6. The image sensor according to claim 5, wherein the readout circuit (6-2) is configured to transfer first electric charges generated in the first photodiode (2) to a first electrically-conductive track (68; 88) and configured to transfer second charges generated in the second photodiode (4) to the first electrically-conductive track (68) or a second electrically-conductive track.

7. The image sensor according to claim 6, wherein the first photodiodes (2) are arranged in rows and in columns and wherein the readout circuits (6-2) are configured to control the generation of the first charges during first time intervals simultaneous for all the first photodiodes (2) of the image sensor.

8. The image sensor according to claim 6 or 7, wherein the second photodiodes (4) are arranged in rows and in columns and wherein the readout circuits (6-2) are configured to control the generation of the second charges during second time intervals simultaneous for all the second photodiodes of the image sensor or shifted in time from one row of second photodiodes to another.

9. The image sensor according to any of claim 6 to 8, wherein the readout circuits (6-2) are configured to control a first integration phase for the first photodiodes (2) having a first duration and to control a second integration phase for the second photodiodes (4) having a second duration different from the first duration.

10. The image sensor according to any of claims 6 to 9, wherein each readout circuit (6-2) comprises at least one first follower-assembled MOS transistor (60), the second photodiode (4) having a first electrode (22) directly coupled to the gate of the first MOS transistor and the second photodiode (2) having a second electrode coupled to the gate of the first MOS transistor, or to the gate of a second follower-assembled MOS transistor (78), via a third MOS transistor (74).

11. The image sensor according to any of claims 1 to 10, wherein the photosensitive layer (26) is made of organic materials and/or contains quantum dots.
